# EUROPÄISCHE PATENTSCHRIFT

(11) **EP 2 871 671 B1**
(45) Veröffentlichungstag und Bekanntmachung des Hinweises auf die Patenterteilung: **01.02.2017**
(21) Anmeldenummer: 14191989.4
(22) Anmeldetag: 06.11.2014
(51) Int. Cl.: H01L 23/34, H01L 23/473, H01L 23/367, F28F 3/02, H01L 21/48, H05K 7/20, F28F 13/08, H01L 23/467

(54) **Kühlkörper**
Cooling element
Dissipateur thermique

(30) Priorität: 06.11.2013 DE 202013104990 U
(43) Veröffentlichungstag der Anmeldung: 13.05.2015
(60) Teilanmeldung: 16178495.4
(73) Patentinhaber: AKG Thermotechnik International GmbH & Co. KG, 34369 Hofgeismar (DE)
(72) Erfinder: Kozica, Michael, 34376 Immenhausen (DE); Wieleke, Fabian, 34246 Vellmar (DE); Zinn, Thomas, 34125 Kassel (DE)
(74) Vertreter: Specht, Peter

(56) Entgegenhaltungen:
- EP-A1- 1 898 464
- EP-A2- 0 004 333
- EP-A2- 0 206 980
- EP-A2- 1 378 940
- WO-A1-02/070977
- WO-A1-2010/006875
- CN-A- 102 231 370
- DE-A1- 3 415 554
- DE-U1- 20 309 856
- JP-A- 2013 125 752
- US-A- 4 884 631
- US-A- 5 072 787
- US-A1- 2005 241 801
- US-A1- 2009 065 187
- US-A1- 2010 236 755

## Beschreibung

Die vorliegende Erfindung betrifft einen Kühlkörper für mindestens ein zu kühlendes Bauelement, insbesondere ein Halbleiterbauelement, gemäß dem Oberbegriff des Anspruchs 1.

Gattungsgemäße Kühlkörper zur Kühlung von insbesondere elektronischen Hochleistungsbauteilen wie beispielsweise IGBT-Baugruppen für Stromrichter, beispielsweise bekannt aus der DE 10 2006 019 376 A1, der DE 43 22 647 A1 oder der DE 93 04 128 U1 dienen dazu, die von diesen Bauelementen erzeugte Wärme abzuleiten und dadurch die Bauelemente zu kühlen.

Die Kühlkörper bestehen dabei in der Regel aus einer Grundplatte, auf der eines oder mehrere dieser Bauteile flächig aufgebracht sind, und einer dieser Bauelementfläche abgewandten Kühlkörperfläche, von der sich Kühlluftkanäle bildende Kühlrippen weg erstrecken. Diese Kühlrippen sind dabei in einer Variante in Nuten einer beispielsweise als Strangpressprofil ausgebildeten Grundplatte eingelassen, so dass die von den Bauteilen erzeugte Wärme durch die Grundplatte in die Kühlrippen geleitet wird und die Kühlrippen ihrerseits unter Ausbildung der oben genannten Kühlluftkanäle bei Durchleitung von Kühlluft durch den Kühlkörper diese Wärme an die durchgeleitete Kühlluft abgeben.

Zur Erzielung einer möglichst hohen Leistung dieser Kühlkörper, sprich einer möglichst effektiven Wärmeabfuhr, ist zum einen eine hohe Rippendichte mit möglichst dünnwandigen Rippenkörper erwünscht, zum zweiten sollte der Druckverlust der Kühlluft beim Durchleiten durch den Kühlkörper möglichst gering sein. Schließlich sollte die Kühlleistung des Kühlkörpers in Kühlluft-Strömungsrichtung durch den Kühlkörper möglichst konstant sein, um auch bei beispielsweise in Kühlluftströmungsrichtung hintereinander gebauten zu kühlenden Bauteilen auch die hinteren Bauteile noch hinreichend kühlen zu können.

Aus der US 5 072 787 A ist ein Kühlkörper bekannt, zur Reduzierung der Maximaltemperatur des Kühlkörpers im Kühlluftausgangsbereich die Kühlrippen mit einem sich in Strömungsrichtung der Kühlluft verjüngenden v-förmigen Spalt auszubilden.

Aus der EP 0 004 333 A2 ist ein Kühlkörper bekannt, bei dem der Querschnitt der Kühlkanäle über die Länge des Kühlkörpers in Kühlluft-Strömungsrichtung in einem ersten Abschnitt konstant gehalten wird und sich in einem sich an diesen anschließenden zweiten Bereich vergrößert.

Aus der EP 1 898 464 A1 ist ein Kühlkörper bekannt, bei dem zwischen benachbarten Kühlrippen Austauscherelemente eingesetzt sind, mit denen das in einem ersten Abschnitt nahe des zu kühlenden Grundkörpers geführte Kühlmedium weggeleitet und in dem ersten Abschnitt fern des zu kühlenden Grundkörpers geführte Kühlmedium nahe zum Grundkörper hingeleitet wird.

Aufgabe der vorliegenden Erfindung ist es, einen Kühlkörper bereitzustellen, mit dem die oben genannten Probleme möglichst effektiv und kostengünstig gelöst werden.

Diese Aufgabe wird durch einen Kühlkörper mit den Merkmalen des Anspruchs 1, gelöst.

Der mit Anspruch 1 beanspruchte Kühlkörper weist eine Grundplatte mit Längsnuten auf, in die mehrere Kühlluftkanäle bildende Kühlrippen eingesetzt sind. Die Kühlrippen sind dabei derart geformt, dass sie in Kühlluft-Strömungsrichtung wenigstens drei ineinander übergehende Kühlluftkanalbereiche bilden. Dabei bilden in einem Kühllufteintrittsbereich nebeneinander angeordnete Kühlrippen teilflächig aneinander liegend zumindest der Grundplatte nahe erste Kühlluftkanäle mit einer Breite b und einer Höhe h aus. In einem sich an diesen anschließenden Übergangsbereich sind die Kühlrippen so geformt, dass sich die Höhe der Kühlluftkanäle vergrößert, während sich die Breite der Kühlluftkanäle verkleinert. Dieser Übergangsbereich mündet dann in einen Endbereich, in dem eine maximale Kanalhöhe und eine minimale Breite der Kühlluftkanäle erreicht ist, wobei in diesem Bereich die Kühlrippen beidseitig und vollflächig von der durch den Kühlkörper durchgeleiteten Kühlluft umströmbar sind.

Durch die derart geformten Kühlrippen ist damit ermöglicht, dass die nahe an der Grundplatte vorbeigeführte Kühlluft im Lufteintrittsbereich, die aufgrund ihrer

Nähe zur Grundplatte bereits stärker erwärmt wird als die weiter entfernt von der Grundplatte durch den Kühlkörper geführte Kühlluft, sich in Kühlluft-Strömungsrichtung weiter hinten nach Durchlauf durch den Übergangsbereich in den Endbereich senkrecht zur Grundplattenfläche weiter verteilt und die Kühlluft, die anfänglich weiter entfernt von der Grundplatte in den Kühlkörper eintritt, bei Erreichen des Endbereichs noch kühler ist als die in der Grundplatte nahen ersten Kühlluftkanälen, so dass dadurch auch in hinteren Bereichen des Kühlkörpers (betrachtet in Kühlluftströmungsrichtung) vergleichsweise kühlere Luft noch nahe der Grundplatte entlanggeführt werden kann und damit zu einer möglichst konstanten Leistung über die gesamte Länge des Kühlkörpers in Kühlluft-Strömungsrichtung beiträgt.

Vorteilhafte Ausgestaltungen der Erfindung sind Gegenstand der Unteransprüche.

Gemäß einer vorteilhaften Ausführungsvariante der Erfindung sind die Kühlrippen im Kühlluft-Eintrittsbereich so geformt, dass sie neben den der Grundplatte nahe ersten Kühlluftkanälen auch der Grundplatte ferne zweite Kühlluftkanäle bilden.

Denkbar ist auch, die Kühlrippen im Kühlluft-Eintrittsbereich so zu formen, dass die Kühlrippenwände, die alternativ die zweiten Kühlluftkanäle bilden, weggeschnitten sind und so ein einziger der Grundplatte ferner Kühlluftkanal im Kühlkörper gebildet ist, was den Druckverlust im Kühlkörper deutlich reduziert.

Im ersten Fall sind die Kühlrippen gemäß einer weiteren bevorzugten Ausführungsvariante im Kühlluft-Eintrittsbereich so geformt, dass die Kühlluftkanäle zwei oder mehr senkrecht zur Kühlkörperfläche übereinander liegende Kühlluftkanal-Etagen bilden, wobei die durch die Kühlrippen gebildeten Kühlluftkanäle insbesondere gleiche Breiten und Höhen aufweisen. Dadurch ist ermöglicht, dass gleichen Mengen an Kühlluft zunächst im Kühlluft-Eintrittsbereich stärker bzw. schwächer erwärmt werden, so dass im hinteren Endbereich noch geringer erwärmte Kühlluft nahe der Grundplatte vorbeigeführt werden kann.

Zur Erzielung eines möglichst geringen Druckverlustes beim Durchströmen der Kühlluft durch die Kühlluftkanäle ist gemäß einer bevorzugten Ausführungsvariante die von der Kühlluft durchströmbare Querschnittsfläche der von den Kühlrippen gebildeten Kühlluftkanäle in allen Kühlluftkanalbereichen gleich oder nahezu gleich. Die bei veränderter Geometrie gleich bleibende Querschnittsfläche sorgt für eine sanfte Umlenkung der Kühlluft in den Kühlluftkanälen und damit für einen sehr geringen Druckverlust.

Die Kühlrippen sind gemäß einer weiteren bevorzugten Ausführungsvariante in Längsnuten der Kühlkörperfläche der Grundplatte verklebt oder verlötet und sorgen so für einen hinreichenden Wärmeaustausch zwischen der Grundplatte und den Kühlrippen.

Gemäß einer weiteren bevorzugten Ausführungsvariante bilden die Kühlrippen in Kühlluft-Strömungsrichtung fünf ineinander übergehende Kühlluftkanalbereiche, wobei sich an einen Endbereich ein zweiter Übergangsbereich anschließt, in dem die Kühlrippen so geformt sind, dass sich die Höhe der Kühlluftkanäle verkleinert, während sich die Breite der Kühlluftkanäle vergrößert, an den sich ein dem Kühlluft-Eintrittsbereich entsprechend aufgebauter Etagenbereich anschließt, wobei die Kühlrippen im zweiten Übergangsbereich so geformt sind, dass die im Kühlluft-Eintrittsbereich der Grundplatte nahen Kühlluftkanäle im Etagenbereich fern der Grundplatte verlaufen und umgekehrt.

Dadurch ist ermöglicht, dass im in Kühlluftströmungsrichtung vorderen Bereich des Kühlkörpers zunächst wenig erwärmte Kühlluft im hinteren Bereich nahe an der Grundplatte vorbeigeführt wird und damit die Kühlleistung im hinteren Bereich des Kühlkörpers verbessert wird.

Gemäß einer weiteren bevorzugten Ausführungsvariante weist der Kühlkörper eine zweite Grundplatte auf, wobei die zweite Grundplatte und die erste Grundplatte die Kühlrippen zwischen sich aufnehmen und die zweite Grundplatte erlaubt dabei die Aufnahme weiterer zu kühlender Bauelemente.

Gemäß einer weiteren bevorzugten Ausführungsvariante erstreckt sich der erste Übergangsbereich in Kühlluftströmungsrichtung nahezu über die gesamte Längserstreckung der Kühlrippen. Ein Kühlkörper mit in dieser Weise ausgebildeten Kühlrippen hat den Vorteil besonders geringer Druckverluste beim Durchgang der Kühlluft in Strömungsrichtung.

Nach einer weiteren bevorzugten Ausführungsvariante des erfindungsgemäßen Kühlkörpers ist von einer benachbarten Kühlrippe jeweils eine der Kühlrippen als ebene Platte ausgebildet. Durch die im Wechsel angeordneten Platten beziehungsweise profilierten Kühlrippen halbiert sich die Anzahl der profilierten Kühlrippen und ermöglicht so eine kostengünstigere Herstellung des erfindungsgemäßen Kühlkörpers.

Nach einer weiteren bevorzugten Ausführungsvariante sind die ersten und/oder zweiten Enden der Kühlrippen derart geformt, dass sie in Kühlluftströmungsrichtung alternierend an den ersten und/oder zweiten Enden jeweils benachbarte Kühlrippen anliegend ausgebildet sind. Die ersten oder zweiten Enden der Kühlrippen sind dabei bevorzugt bei einem Prägen oder Stanzen der Kühlrippen als wellenförmiger Abstandshalter geformt, die die gewünschte Rippenteilung an den Enden, sprich an Fuß und an den Spitzen der Kühlrippen sicherstellen.

Nachfolgend werden Ausführungsbeispiele der Erfindung anhand der beiliegenden Zeichnungen näher erläutert. Es zeigen:
- Figur 1: eine perspektivische Ansicht einer Ausführungsvariante eines erfindungsgemäßen Kühlkörpers mit auf einer Grundplatte des Kühlkörpers aufgebrachten zu kühlenden Bauteilen,
- Figur 2: eine perspektivische Ansicht eines Ausschnitts des Kühlkörpers zur Darstellung des prinzipiellen Aufbaus, mit einer Grundplatte mit Nuten und darin einsteckbare Kühlrippen,
- Figur 3 a): eine perspektivische Ansicht des Kühlkörpers aus Figur 1 zur Darstellung mehrerer in den Figuren 3b), c) und d) gezeigten Schnitten durch den Kühlkörper, wobei

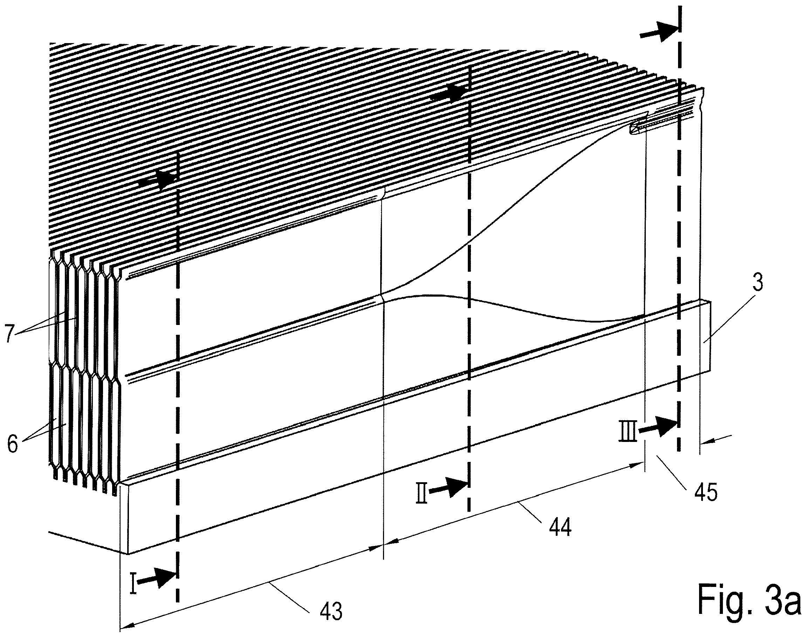

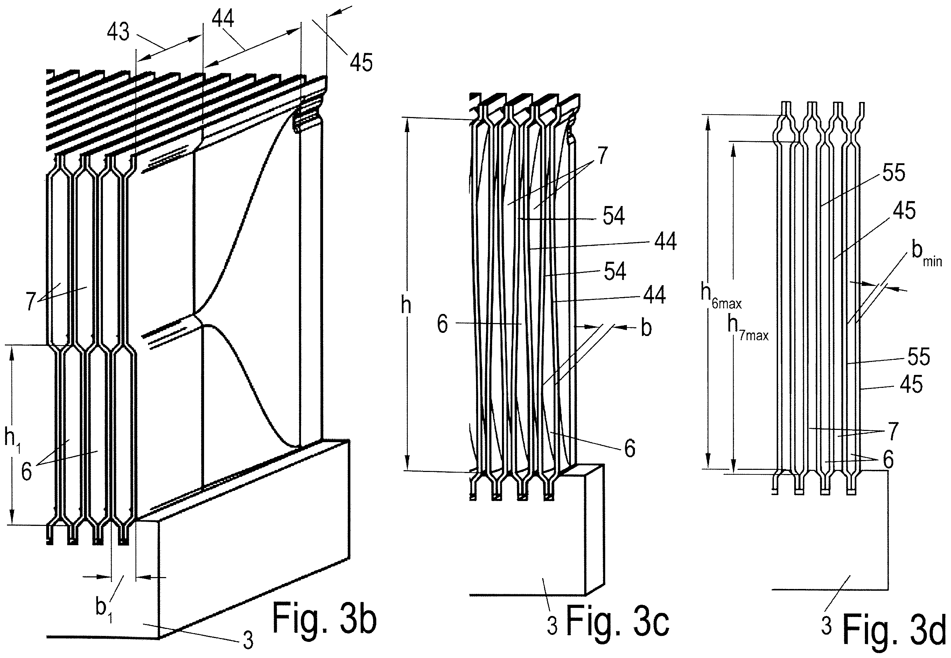

- Figur 3 b): eine perspektivische Ansicht zur Darstellung eines Kühlluft-Eintrittsbereichs entlang einer mit I in Figur 3a) bezeichneten Schnittebene zeigt,
- Figur 3 c): eine perspektivische Ansicht des Kühlkörpers entlang einer mit II in Figur 3a) bezeichneten Schnittebene,
- Figur 3 d): eine Schnittansicht durch eine mit III in Figur 3a) dargestellte Schnittebene, darstellend den Endbereich,

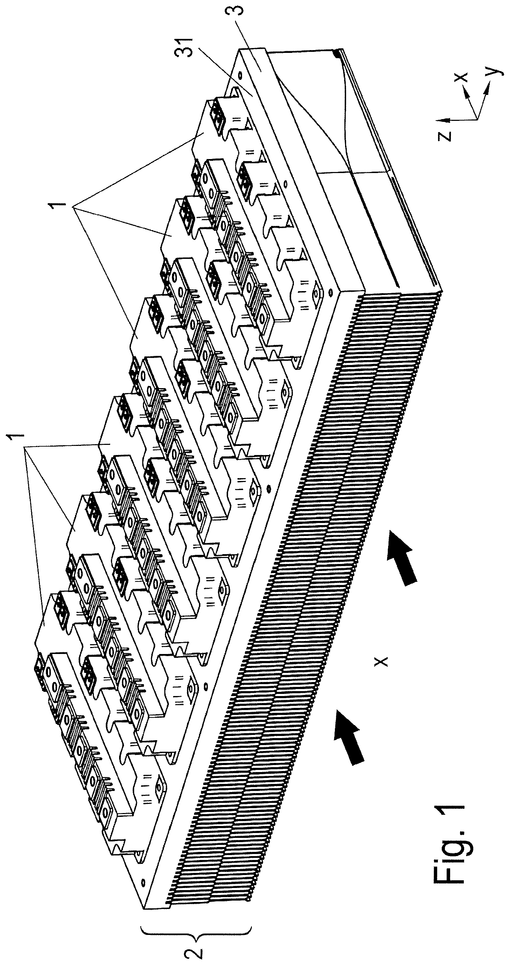

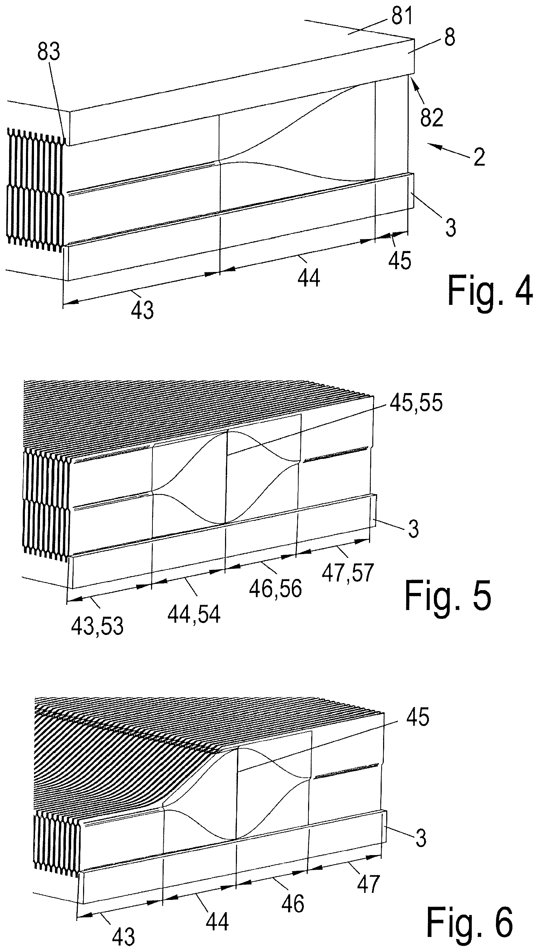

- Figur 4: eine perspektivische Ansicht einer alternativen Ausführungsvariante des Kühlkörpers aus Figur 1 mit zwei Grundplatten,
- Figur 5: eine perspektivische Ansicht einer weiteren Ausführungsvariante eines Kühlkörpers mit insgesamt fünf Kühlluftkanalbereichen,
- Figur 6: eine schematische Darstellung einer nochmals weiteren Ausführungsvariante des Kühlkörpers, bei dem die oberen Kühlluftkanäle im Kühlluft-Eintrittsbereich weggeschnitten sind,

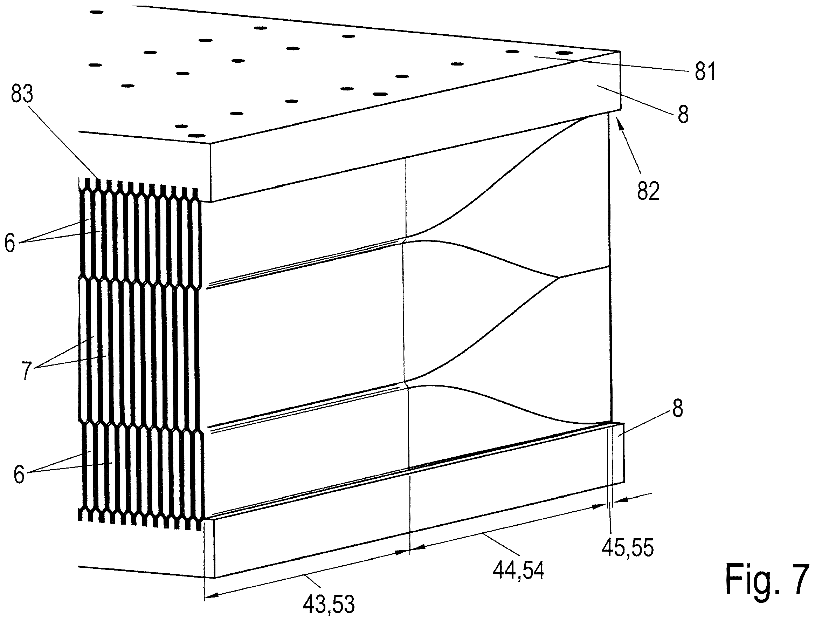

- Figur 7: eine schematische Darstellung einer nochmals weiteren Ausführungsvariante des Kühlkörpers mit zwei Grundplatten, mit im Kühlluft-Eintrittsbereich jeweils ersten den Grundplatten nahen Kühlluftkanäle und dazwischen angeordneten zweiten Kühlluftkanälen,

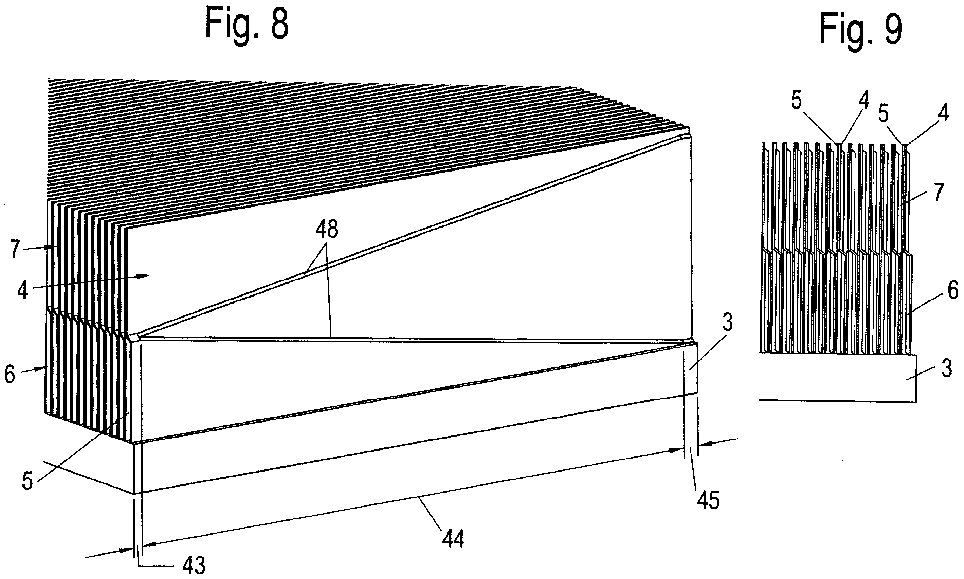

- Figur 8: eine perspektivische Ansicht einer weiteren Ausführungsvariante eines erfindungsgemäßen Kühlkörpers mit sich nahezu über die gesamte Länge erstreckenden ersten Übergangsbereich,

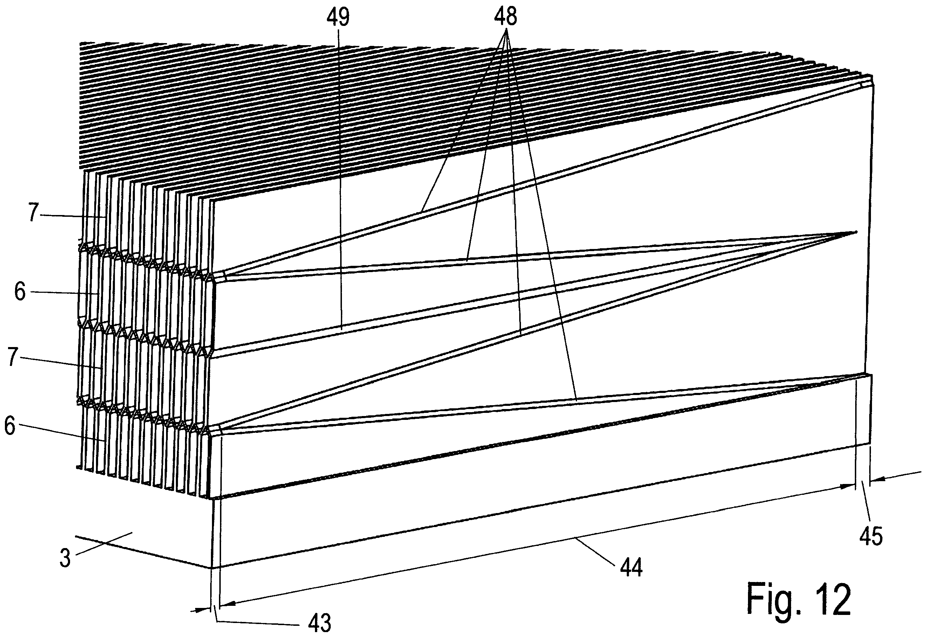

- Figur 9: eine Ansicht von vorn auf den in Figur 12 gezeigten Kühlkörper,

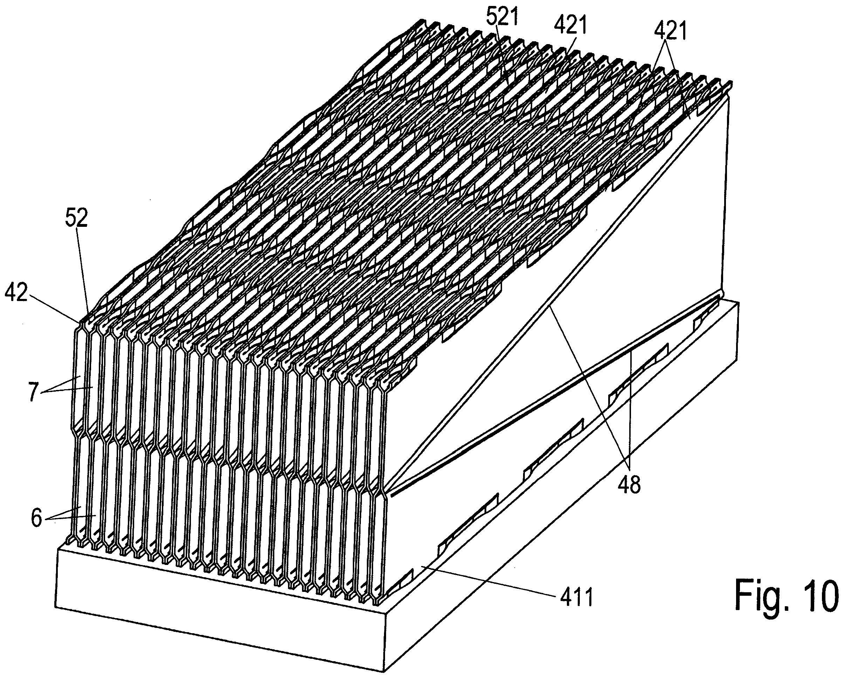

- Figur 10: eine perspektivische Ansicht einer weiteren Ausführungsvariante eines erfindungsgemäßen Kühlkörpers mit als Abstandshalter ausgebildeten Enden der Kühlrippen,

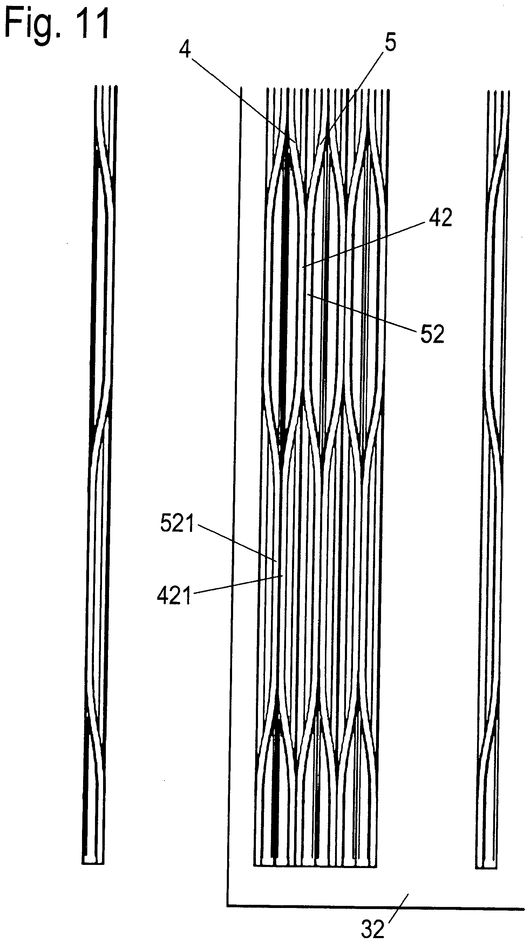

- Figur 11: eine Draufsicht auf den in Figur 14 gezeigten Kühlkörper, und
- Figur 12: eine perspektivische Ansicht einer nochmals weiteren Ausführungsvariante eines erfindungsgemäßen Kühlkörpers mit insgesamt vier vertikal übereinander angeordneten Kühlluftkanalebenen.

In der nachfolgenden Figurenbeschreibung beziehen sich Begriffe wie oben, unten, links, rechts, vorne, hinten usw. ausschließlich auf die in den jeweiligen Figuren ausgewählte beispielhafte Darstellung und Position des Kühlkörpers, der Grundplatte, Kühlrippen, Kühlluftkanäle, Stege und dergleichen. Diese Begriffe sind nicht einschränkend zu verstehen, d. h., durch verschiedene Arbeitsstellungen oder die spiegelsymmetrische Auslegung oder dergleichen können sich diese Bezüge ändern.

In der Figur 1 ist mit dem Bezugszeichen 2 insgesamt eine Ausführungsvariante eines erfindungsgemäßen Kühlkörpers bezeichnet. Der Kühlkörper 2 besteht dabei im Wesentlichen aus einer Grundplatte 3 mit einer Bauelementfläche 31, auf der eins oder mehrere zu kühlende Bauelemente 1, beispielsweise in der Gestalt von zu kühlenden Elektronikbauteilen wie beispielsweise IGBT-Baugruppen eines Stromrichters, befestigbar sind, sowie einer umseitigen Kühlkörperfläche 32, die mit Längsnuten 33 versehen ist sowie eine Vielzahl von bevorzugt als Profilbleche ausgebildeten Kühlrippen 4, 5, die mit jeweiligen ersten Enden 41, 51 in die Längsnuten 33 der Kühlkörperfläche 32 der Grundplatte 3 eingesetzt sind.

Die Kühlrippen 4, 5 bilden dabei im verbauten Zustand eine Vielzahl von Kühlluftkanälen 6, 7, durch die Kühlluft in Kühlluftströmungsrichtung x durch den Kühlkörper 2 strömen kann, um die durch die Abwärme der Bauelemente 1 erwärmte Grundplatte 3 und die an diesen befestigten Kühlrippen 4, 5 zu kühlen.

Wie in den Figuren 1, 2 und 3 a) bis 3 d) gezeigt ist, sind die Kühlrippen 4, 5 dabei in Kühlluft-Strömungsrichtung x in wenigstens drei ineinander übergehende Kühlluftkanalbereiche 43, 44, 45, 53, 54, 55 unterteilt, wobei die Kühlrippen 4, 5 im in Kühlluftströmungsrichtung x zu Beginn durchströmten Kühlluft-Eintrittsbereich 43, 53 derart geformt, dass die Kühlrippen 4, 5 teilflächig aneinander liegend zumindest der Grundplatte 3 nahe erste Kühlluftkanäle 6 mit einer Breite b1 und einer Höhe h1 ausbilden.

Dabei ist es denkbar, dass die Kühlrippen 4, 5, wie es in Figur 6 gezeigt ist, im Kühlluft-Eintrittsbereich in vertikaler Richtung z oberhalb des ersten Kühlluftkanals 6 enden und im sich daran anschließenden Übergangsbereich 44, 54 bevorzugt kontinuierlich höher gebaut sind, bis eine Maximalhöhe hₘₐₓ im Endbereich 45, 55 erreicht ist.

In der in den Figuren 1-5 gezeigten Variante sind die Kühlrippen 4, 5 von gleichbleibender vertikaler Höhe h in Z-Richtung, sprich parallel zur Normalen der Bauelementfläche 31, und dabei derart geformt, dass die Kühlrippen 4, 5 im Kühlluft-Eintrittsbereich 43, 53 zusätzlich der Grundplatte 3 ferne zweite Kühlluftkanäle 7 bilden. Die Kühlluftkanälen 6, 7 sind in diesem Kühlluft-Eintrittsbereich 43, 53 in Form von zwei senkrecht zur Kühlkörperfläche 32 übereinander liegenden Kühlluftkanaletagen angeordnet, wobei die einzelnen Kühlluftkanäle 6, 7 vorzugsweise gleiche Breiten b und Höhen h aufweisen.

Denkbar ist auch, je nach geforderten Parametern, die Abmessungen der Kühlluftkanäle 6, 7 unterschiedlich zu gestalten, insbesondere die der Grundplatte 3 nahen ersten Kühlluftkanäle 6 höher auszubilden als die der Grundplatte 3 fernen zweiten Kühlluftkanäle 7.

Im sich an den Kühlluft-Eintrittsbereich 43, 53 anschließenden Übergangsbereich 44, 54 sind die Kühlrippen 4, 5 so geformt, dass sich die Höhe h der Kühlluftkanäle 6, 7, bevorzugt kontinuierlich, vergrößert, während sich die Breite b der Kühlluftkanäle 6, 7, bevorzugt kontinuierlich, verkleinert, bis eine maximale Kanalhöhe h₆ₘₐₓ und h₇ₘₐₓ und eine minimale Breite bₘᵢₙ erreicht ist, welche dann den sich an den Übergangsbereich 44, 54 anschließenden Endbereich 45, 55 definiert.

Während durch das teilweise Anliegen der Kühlrippen 4, 5 im Kühlluft-Eintrittsbereich 43, 53 die Kühlrippen 4, 5 jeweils nur einseitig von der Kühlluft angeströmt werden, ist die von Kühlluft anströmbare Fläche der Kühlrippen 4, 5 im Endbereich 45, 55 etwa verdoppelt, da die Kühlrippen 4, 5 in diesem Bereich nicht mehr aneinander liegen und dadurch beidseitig und vollflächig von Kühlluft umströmbar sind, was eine hohe Wärmeübertragung ermöglicht.

Die Formänderung der Kühlrippen 4, 5 zwischen den einzelnen Kühlluftkanalbereichen erfolgt dabei bevorzugt derart, dass die von der Kühlluft durchströmbare Querschnittsfläche der von den Kühlrippen 4, 5 gebildeten Kühlluftkanäle 6, 7 trotz veränderter Geometrie gleich bleibt. Dadurch wird eine sanfte Umlenkung des Kühlluftstroms in den Kühlluftkanälen 6, 7 bewirkt, die den Druckverlust des Kühlluftstroms sehr klein hält.

Wie außerdem in Figur 3 d) gut zu erkennen ist, sind die Kühlrippen 4, 5 im Endbereich 45, 55 im Bereich zwischen ihren jeweiligen Enden 41, 42 und 51, 52 als parallel nebeneinander stehende ebene Platten ausgebildet, während sie im Kühlluft-Eintrittsbereich 43, 53, gezeigt in Figur 3 b) in diesem Bereich zur Ausbildung von Teilwandungen für mehrere übereinander angeordnete Kühlluftkanäle 6, 7 etwa s-förmig verbogen sind.

Die Breite der Längsnuten 33 der Grundplatte 3 ist so ausgelegt, dass jeweils die ersten Enden 41, 51 zweier Kühlrippen 4, 5 gemeinsam in eine solche Längsnut 33 einsetzbar sind. Die Kühlrippen 4, 5 sind dabei bevorzugt in diesen Längsnuten 33 der Kühlkörperfläche 32 der Grundplatte 3 verklebt oder verlötet, insbesondere durch induktives Erwärmen. Denkbar ist auch ein Verpressen der Kühlrippen 4, 5 in diesen Längsnuten 33 der Kühlkörperfläche 32 der Grundplatte 3.

Denkbar ist auch der Einsatz einer Grundplatte 3 ohne Längsnuten 33 in der Kühlkörperfläche 32, bei der die Kühlrippen 4, 5 direkt auf die Kühlkörperfläche 32 aufgelötet, insbesondere induktionsverlötet, oder mithilfe eines wärmeleitfähigen Klebers verklebt werden. Wichtig ist eine gute Wärmeanbindung der Grundplatte 3 an die Kühlrippen 4, 5, um eine zum Abtransport der durch die zu kühlenden Bauteile 1 erzeugte Abwärme in hinreichendem Maße zu gewährleisten.

Wie in Figur 4 gezeigt, ist es ebenso denkbar, die Kühlrippen 4, 5 zwischen zwei die Kühlrippen 4, 5 einschließenden Grundplatten 3, 8 aufzunehmen, wobei die zweite Grundplatte 8 entsprechend der oben beschriebenen Grundplatte 3 ausgebildet ist, mit einer Bauelementfläche 81 zur Aufbringung mindestens eines zu kühlenden Bauelements 1 und einer umseitigen Kühlkörperfläche 82, welche ebenfalls mit Längsnuten 83 versehen ist, zur Aufnahme jeweiliger zweiter Enden 42, 52 der Kühlrippen 4, 5.

Bei den in den Figuren 5 und 6 gezeigten Ausführungsvarianten eines erfindungsgemäßen Kühlkörpers 2 sind die Kühlrippen 4, 5 in Kühlluftströmungsrichtung x so geformt, dass sie insgesamt fünf ineinander übergehende Kühlluftkanalbereiche 43, 44, 45, 46, 47, 53, 54, 55, 56, 57 bilden, wobei die ersten drei Bereiche wie oben beschrieben ausgebildet sind und sich quasi spiegelbildlich an einen Endbereich 45, 55 der Kühlrippen 4, 5 ein zweiter Übergangsbereich 46, 56 anschließt, in dem die Kühlrippen 4, 5 so geformt sind, dass sich die Höhe h der Kühlluftkanäle 6, 7 verkleinert, während sich die Breite b der Kühlluftkanäle 6, 7 vergrößert.

An diesen zweiten Übergangsbereich 46, 56 schließt sich noch ein dem Kühlluft-Eintrittsbereich 43, 53 entsprechend aufgebauter Etagenbereich 47, 57 an, wobei die Kühlrippen 4, 5 in diesem zweiten Übergangsbereich 46, 56 so geformt sind, dass sich die im Kühlluft-Eintrittsbereich 43, 53 der Grundplatte 3 nahen Kühlluftkanäle 6 im Etagenbereich 47, 57 fern der Grundplatte 3 verlaufen. Entsprechend sind im zweiten Übergangsbereich 46, 56 die Kühlluftkanäle 7, die im Kühlluft-Eintrittsbereich 43, 53 entfernt von der Grundplatte 3 verlaufen, im Etagenbereich 47, 57 nunmehr nah der Grundplatte 3.

Dadurch wird erzwungen, dass die im Kühlluft-Eintrittsbereich 43, 53 bereits stärker erwärmte Kühlluft, die durch die Kühlluftkanäle 6 strömt, im Etagenbereich nach oben, sprich weg von der Grundplatte 3 abgeführt wird und die relativ dazu kühlere Kühlluft aus den Kühlluftkanälen 7 im Etagenbereich 47, 57 an der Grundplatte 3 entlang geführt wird.

Die Wegnahme der im Kühlluft-Eintrittsbereich 43, 53 oberen Kühlluftkanäle 7, wie es in Figur 6 gezeigt ist, wurde bereits weiter oben beschrieben.

Bei der in Figur 7 gezeigten Ausführungsvariante des Kühlkörpers sind die Kühlrippen 4, 5, wie bereits in der in Figur 4 gezeigten Ausführungsvariante, zwischen zwei die Kühlrippen 4, 5 einschließenden Grundplatten 3, 8 aufgenommen, wobei die die Kühlrippen 4, 5 hier vorzugsweise derart ausgebildet sind, dass sie im Kühlluft-Eintrittsbereich 43, 53 drei Kühlluftkanaletagen bilden, und zwar jeweilige den Grundplatte 3, 8 nahe erste Kühlluftkanäle 6 und zwischen den ersten Kühlluftkanälen 6 angeordnete zweite Kühlluftkanäle 7. Die Höhe h der zweiten Kühlluftkanäle 7 kann dabei, wie in Figur 7 gezeigt, etwa die doppelte Höhe der den Grundplatte 3, 8 nahen ersten Kühlluftkanäle 6 betragen. Denkbar sind aber auch andere Höhen- und/oder Breitenverhältnisse.

Möglich sind auch weitere Kombinationen der in den Figuren 1 bis 7 dargestellten prinzipiellen Bauweisen. So ist es auch denkbar, bei der in Figur 7 gezeigten Ausführungsvariante den Bereich der zweiten Kühlluftkanäle 7 entsprechend der in Figur 6 gezeigten und beschriebenen Ausführungsvariante und/oder die Kühlrippen 4, 5 in Kühlluftströmungsrichtung x entsprechend der in Figur 5 gezeigten und beschriebenen Ausführungsvariante mit insgesamt fünf ineinander übergehende Kühlluftkanalbereiche 43, 44, 45, 46, 47, 53, 54, 55, 56, 57 zu gestalten.

In einer nochmals alternativen Ausführungsvariante, gezeigt in den Figuren 8 bis 12, erstreckt sich der Übergangsbereich 44, 54 in Kühlluftströmungsrichtung x dazu über die gesamte Längserstreckung der Kühlrippen 4, 5. Die vorzugsweise durch Prägen oder Stanzen erzeugten Kühlrippen 4, 5 weisen dabei bevorzugt gradlinige Stufen 48 auf, die im Eintrittsbereich 43, 53 zusammen laufen und sich in Kühlluftströmungsrichtung x in Richtung des Endbereiches 45, 55 voneinander entfernen.

Bei der in den Figuren 8 und 9 gezeigten Ausführungsvariante ist außerdem nur jede zweite der Kühlrippen 4 als profilierte Kühlrippe ausgebildet, während die dieser benachbarte Kühlrippe 5 als ebene Platte ausgebildet ist. Dies hat den Vorteil, dass im Gegensatz zu der Ausführungsvariante gemäß den Figuren 1 bis 7 nur die Hälfte der Kühlrippen 4, 5 eines solchen Kühlkörpers profiliert werden müssen.

Bei der in den Figuren 10 und 11 gezeigten vorteilhaften Ausführungsvariante des Kühlkörpers sind die Enden 41 und die diesen gegenüber liegenden Enden 42 derart geformt, dass sie in Kühlluftströmungsrichtung x alternierend an den ersten und/oder zweiten Enden 51, 52, 41, 42 jeweils benachbarte Kühlrippen 5, 4 anliegend ausgebildet sind.

Die Enden 41, 42, 51, 52 der Kühlrippen 4, 5 bilden dabei bevorzugt wellenförmige Abstandshalter aus, die ohne zusätzliche Fertigungs- oder Materialkosten beim Prägen oder Stanzen der Kühlrippen 4, 5 angeformt werden und so die gewünschte Rippenteilung an den Enden, sprich am Fuß und an den Spitzen der Kühlrippen 4, 5 sicherstellen.

Die Befestigung der Kühlrippen 4, 5 erfolgt hier bevorzugt durch stumpfes Auflöten der Enden 41, 51 der Kühlrippen 4, 5 auf die ebene Grundplatte 3. Dadurch kann auf ein Einbringen von Längsnuten in die Grundplatte verzichtet werden.

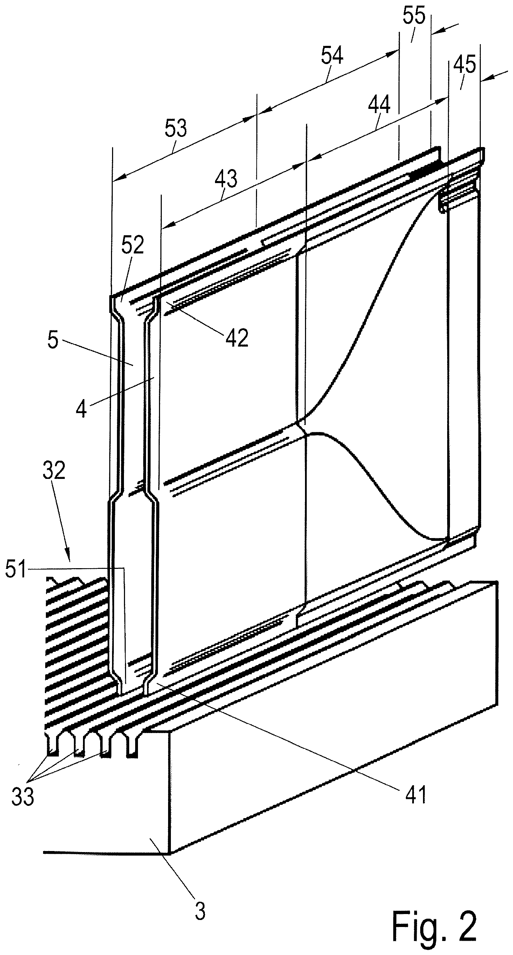

Denkbar ist auch, die Enden 41 entsprechend der in Figur 2 gezeigten Ausführungsvariante in die Grundplatte 3 einzustecken. Dementsprechend sind bei dieser Ausführungsvariante die Längsnuten 33 in der Grundplatte 3 an den Verlauf der Enden 41, 42 angepasst, bei der hier gezeigten Ausführungsvariante dementsprechend wellenförmig ausgebildet.

Wie besonders gut in Figur 10 zu erkennen ist, sind Anlagestege 411, 421, 521, an den jeweiligen Enden 41, 42 der Kühlrippen 4, 5 angeformt, die an entsprechenden Flächen der benachbarten Kühlrippe 5, 4 anliegen und so eine zuverlässige Beibehaltung der gewünschten Abstände zwischen den einzelnen Kühlrippen 4, 5 gewährleisten.

In Figur 12 eine Ausführungsvariante eines erfindungsgemäßen Kühlkörpers 2 gezeigt, mit sich nahezu über die gesamte Länge der Kühlrippen in Kühlluftströmungsrichtung x erstreckenden ersten Übergangsbereich 44, 54 sowie einer Formgestaltung senkrecht zur Ebene der Grundplatte 3, bei der vier Kühlluftkanäle 6, 7 übereinander angeordnet sind.

Dementsprechend sind in den Kühlrippen 4, 5 vier schräg verlaufende Stufen 48 angeformt, sowie eine sich in Kühlluftströmungsrichtung x erstreckende weitere Stufe 49 auf halber Höhe der Kühlrippe 4.

### Bezugszeichenliste

- 1: Bauelement
- 2: Kühlkörper
- 3: Grundplatte
- 31: Bauelementefläche
- 32: Kühlkörperfläche
- 33: Längsnuten

- 4: Kühlrippe
- 41: erstes Ende
- 411: Anlagefläche

- 42: zweites Ende
- 421: Anlagefläche

- 43: Kühlluftkanalbereich (Eintrittsbereich)
- 44: Kühlluftkanalbereich (Übergangsbereich)
- 45: Kühlluftkanalbereich (Endbereich)
- 46: Kühlluftkanalbereich (Übergangsbereich)
- 47: Kühlluftkanalbereich (Etagenbereich)
- 48: Stufe
- 49: Stufe

- 5: Kühlrippe
- 51: erstes Ende

- 52: zweites Ende
- 521: Anlagefläche

- 53: Kühlluftkanalbereich (Eintrittsbereich)
- 54: Kühlluftkanalbereich (Übergangsbereich)
- 55: Kühlluftkanalbereich (Endbereich)
- 56: Kühlluftkanalbereich (Übergangsbereich)
- 57: Kühlluftkanalbereich (Etagenbereich)

- 6: Kühlluftkanal
- 7: Kühlluftkanal

- 8: Grundplatte
- 81: Bauelementefläche
- 82: Kühlkörperfläche
- 83: Längsnuten

- bₘᵢₙ: minimale Breite
- b, b₁: Breite

- h, h₁: Höhe
- h₆ₘₐₓ: maximale Kanalhöhe
- h₇ₘₐₓ: maximale Kanalhöhe
- hₘₐₓ: Maximalhöhe

- x: Kühlluftströmungsrichtung

## Patentansprüche

1. Kühlkörper (2) für mindestens ein zu kühlendes Bauelement (1), insbesondere ein Halbleiterbauelement, aufweisend eine Grundplatte (3) mit einer Bauelementfläche (31), auf der das mindestens eine zu kühlende Bauelement (1) befestigbar ist, und einer umseitigen Kühlkörperfläche (32) sowie mehrere Kühlluftkanäle (6, 7) bildende Kühlrippen (4, 5), die mit jeweiligen ersten Enden (41, 51) an der Kühlkörperfläche (32) der Grundplatte (3) befestigt sind, wobei die Kühlrippen (4, 5) in Kühlluftströmungsrichtung (x) wenigstens drei ineinander übergehende Kühlluftkanalbereiche (43, 44, 45, 53, 54, 55) bilden, wobei in einem Kühllufteintrittsbereich (43, 53) nebeneinander angeordnete Kühlrippen (4, 5) teilflächig aneinander liegend zumindest der Grundplatte (3) nahe erste Kühlluftkanäle (6) mit einer Breite (b₁) und einer Höhe (h₁) ausbilden, **dadurch gekennzeichnet, dass** in einem sich anschließenden ersten Übergangsbereich (44, 54) die Kühlrippen (4, 5) so geformt sind, dass sich die Höhe (h) der Kühlluftkanäle (6, 7) vergrößert, während sich die Breite (b) der Kühlluftkanäle (6, 7) verkleinert, wobei in einem sich anschließenden Endbereich (45, 55), in dem eine maximale Kanalhöhe (h₆ₘₐₓ, h₇ₘₐₓ) und eine minimale Breite (bₘᵢₙ) der Kühlluftkanäle (6, 7) erreicht ist, die Kühlrippen (4, 5) beidseitig vollflächig von Kühlluft umströmbar sind.

2. Kühlkörper (2) nach Anspruch 1, **dadurch gekennzeichnet, dass** die Kühlrippen (4, 5) im Kühllufteintrittsbereich (43, 53) der Grundplatte (3) ferne zweite Kühlluftkanäle (7) bilden.

3. Kühlkörper (2) nach Anspruch 2, **dadurch gekennzeichnet, dass** die Kühlrippen (4, 5) im Kühllufteintrittsbereich (43, 53) so geformt sind, dass die Kühlluftkanäle (6, 7) zwei oder mehr senkrecht zur Kühlkörperfläche (32) übereinander liegende Kühlluftkanaletagen bilden.

4. Kühlkörper (2) nach Anspruch 2 oder 3, **dadurch gekennzeichnet, dass** die Kühlluftkanäle (6, 7) im Kühllufteintrittsbereich (43, 53) gleiche Breiten (b) und gleiche Höhen (h) aufweisen.

5. Kühlkörper (2) nach Anspruch 2 oder 3, **dadurch gekennzeichnet, dass** die Kühlluftkanäle (6, 7) im Kühllufteintrittsbereich (43, 53) voneinander verschiedene Breiten (b) und/oder Höhen (h) aufweisen.

6. Kühlkörper (2) nach einem der vorstehenden Ansprüche, **dadurch gekennzeichnet, dass** die von der Kühlluft durchströmbare Querschnittsfläche der von den Kühlrippen (4, 5) gebildeten Kühlluftkanäle (6, 7) in allen Kühlluftkanalbereichen gleich oder nahezu gleich ist.

7. Kühlkörper (2) nach einem der vorstehenden Ansprüche, **dadurch gekennzeichnet, dass** die Kühlkörperfläche (32) der Grundplatte (3) in Kühlluftströmungsrichtung (x) ausgerichtete Längsnuten (33) aufweist, wobei jeweils zwei der Kühlrippen (4, 5) nebeneinander in eine der Längsnuten (33) der Kühlkörperfläche (32) der Grundplatte (3) einsetzbar sind.

8. Kühlkörper (2) nach einem der vorstehenden Ansprüche, **dadurch gekennzeichnet, dass** sich der erste Übergangsbereich (44, 54) in Kühlluftströmungsrichtung (x) nahezu über die gesamte Längserstreckung der Kühlrippen (4, 5) erstreckt.

9. Kühlkörper (2) nach einem der vorstehenden Ansprüche, **dadurch gekennzeichnet, dass** von einander benachbarten Kühlrippen (4, 5) jeweils eine der Kühlrippen (4) als ebene Platte ausgebildet ist.

10. Kühlkörper (2) nach einem der vorstehenden Ansprüche, **gekennzeichnet durch** eine zweite Grundplatte (8) mit einer Bauelementfläche (81), auf der mindestens ein weiteres zu kühlende Bauelement (1) befestigbar ist, und einer umseitigen Kühlkörperfläche (82) mit Längsnuten (83) zur Aufnahme von jeweiligen zweiten Enden (42, 52) der Kühlrippen (4, 5).

11. Kühlkörper (2) nach einem der vorstehenden Ansprüche, **dadurch gekennzeichnet, dass** die ersten und/oder zweiten Enden (41, 42, 51, 52) der Kühlrippen (4, 5) derart geformt sind, dass sie in Kühlluftströmungsrichtung (x) alternierend an den ersten und/oder zweiten Enden (51, 52, 41, 42,) jeweils benachbarter Kühlrippen (5, 4) anliegend ausgebildet sind, wobei die ersten und/oder zweiten Enden (41, 42, 51, 52) der Kühlrippen (4, 5) bevorzugt auf eine Kühlkörperfläche (32) der Grundplatte (3, 8) aufgelötet sind.

## Claims

1. A heat sink (2) for at least one component (1) to be cooled, especially a semiconductor component, comprising a base plate (3) with a component surface (31) to which the at least one component (1) to be cooled can be fixed, and a heat sink surface (32) on the reverse side, as well as several cooling fins (4, 5) which form cooling air channels (6, 7) and which are fastened with respective first ends (41, 51) to the heat sink surface (32) of the base plate (3), wherein the cooling fins (5) form at least three merging cooling air channel regions (43, 44, 45, 53, 54, 55) in the cooling air flow direction (x), wherein in one cooling air entrance region (43, 53) cooling ribs (4, 5), which are arranged adjacent to each other and rest on each other at least over a partial area at least close to the base plate (3), form first cooling air channels (6) with a width (b₁) and a height (h₁), **characterized in that** in an adjoining first transitional region (44, 54) the cooling fins (4, 5) are formed in such a way that the height (h) of the cooling air channels (6, 7) increases, while the width (b) of the cooling air channels (6, 7) decreases, wherein in an adjoining end region (45, 55), in which a maximum channel height (h₆ₘₐₓ, h₇ₘₐₓ) and a minimum width (bₘᵢₙ) of the cooling air channels (6, 7) is reached, cooling air can flow around the cooling ribs (4, 5) on both sides over the entire surface area.

2. A heat sink (2) according to claim 1, **characterized in that** cooling fins (4, 5) form remote second cooling air channels (7) in the cooling air entrance region (43, 53) of the base plate (3).

3. A heat sink (2) according to claim 2, **characterized in that** cooling fins (4, 5) are formed in the cooling air entrance region (3, 53) in such a way that the cooling air channels (6, 7) form two or more cooling air channel levels which are disposed on top of each other perpendicularly to the heat sink surface (32).

4. A heat sink (2) according to claim 2 or 3, **characterized in that** the cooling air channels (6, 7) have the same widths (b) and the same heights (h) in the cooling air entrance region (43, 53).

5. A heat sink (2) according to claim 2 or 3, **characterized in that** the cooling air channels (6, 7) in the cooling air entrance region (43, 53) have widths (b) and/or heights (h) which differ from each other.

6. A heat sink (2) according to one of the preceding claims, **characterized in that** the cross-sectional surface, through which cooling air can flow, of the cooling air channels (6, 7) formed by the cooling fins (4, 5) is identical or nearly identical in all cooling air channel regions.

7. A heat sink (2) according to one of the preceding claims, **characterized in that** the heat sink surface (32) of the base plate (3) comprises longitudinal grooves (33) which are oriented in the cooling air flow direction (x), wherein two each of the cooling fins (4, 5) can be inserted adjacent to each other into one of the longitudinal grooves (33) of the heat sink surface (32) of the base plate (3).

8. A heat sink (2) according to one of the preceding claims, **characterized in that** the first transitional region (44, 54) extends in the cooling air flow direction (x) nearly over the entire longitudinal extension of the cooling fins (4, 5).

9. A heat sink (2) according to one of the preceding claims, **characterized in that** of the mutually adjacent cooling fins (4, 5) one of the cooling fins (4) is formed as a flat plate.

10. A heat sink (2) according to one of the preceding claims, **characterized by** a second base plate (8) with a component surface (81) to which the at least one further component (1) to be cooled can be fastened, and a heat sink surface (82) on the reverse side with longitudinal grooves (83) for accommodating respective second ends (42, 52) of the cooling fins (4, 5).

11. A heat sink (2) according to one of the preceding claims, **characterized in that** the first and/or second ends (41, 42, 51, 52) of the cooling fins (4, 5) are formed in such a way that in the cooling air flow direction (x) they are designed to rest in an alternating manner on the first and/or second ends (51, 52, 41, 42) of respectively adjacent cooling fins (5, 4), wherein the first and/or the second ends (41, 42, 51, 52) of the cooling fins (4, 5) are preferably soldered onto a heat sink surface (32) of the base plate (3, 8).

## Revendications

1. Radiateur (2) pour au moins un élément à refroidir (1), en particulier un élément à semi-conducteurs, présentant une platine de base (3) avec une surface d'élément (31) sur laquelle l'au moins un élément à refroidir (1) peut être fixé et avec une surface de radiateur (32) opposée et plusieurs ailettes de refroidissement (4, 5) formant des canaux à air de refroidissement (6, 7) qui sont fixées à leur première extrémité (41, 51) sur la surface de radiateur (32) de la platine de base (3), les ailettes de refroidissement (4, 5) formant dans le sens de circulation de l'air de refroidissement (x) au moins trois zones de canaux à air de refroidissement (43, 44, 45, 53, 54, 55) se succédant les unes aux autres, des ailettes de refroidissement (4, 5) disposées les unes à côté des autres dans une zone d'entrée de l'air de refroidissement (43, 53) et s'appuyant les une sur les autres sur une partie de la surface formant au moins près de la platine de base (3) des premiers canaux à air de refroidissement (6) ayant une largeur (b₁) et une hauteur (h₁), **caractérisé en ce que** dans la première zone de transition (44, 54) qui suit, les ailettes de refroidissement (4, 5) sont formées de telle sorte que la hauteur (h) des canaux à air de refroidissement (6, 7) augmente tandis que la largeur (b) des canaux à air de refroidissement (6, 7) diminue, les ailettes de refroidissement (4, 5) pouvant être parcourues sur toute leur surface par l'air de refroidissement dans une zone d'extrémité (45, 55) qui suit, dans laquelle les canaux à air de refroidissement (6, 7) atteignent une hauteur maximale (h₆ₘₐₓ, h₇ₘₐₓ) et une largeur minimale (bₘᵢₙ).

2. Radiateur (2) selon la revendication 1, **caractérisé en ce que** les ailettes de refroidissement (4, 5) forment dans la zone d'entrée de l'air de refroidissement (43, 53) des deuxièmes canaux à air de refroidissement (7) éloignés de la platine de base (3).

3. Radiateur (2) selon la revendication 2, **caractérisé en ce que** les ailettes de refroidissement (4, 5) sont conformées dans la zone d'entrée de l'air de refroidissement (43, 53) de telle manière que les canaux à air de refroidissement (6, 7) forment deux ou plusieurs étages de canaux de refroidissement superposés perpendiculairement à la surface de radiateur (32).

4. Radiateur (2) selon la revendication 2 ou 3, **caractérisé en ce que** les canaux à air de refroidissement (6, 7) de la zone d'entrée de l'air de refroidissement (43, 53) ont la même largeur (b) et la même hauteur (h).

5. Radiateur (2) selon la revendication 2 ou 3, **caractérisé en ce que** les canaux à air de refroidissement (6, 7) de la zone d'entrée de l'air de refroidissement (43, 53) ont des largeur (b) et/ou des hauteurs (h) différentes.

6. Radiateur (2) selon l'une des revendications précédentes, **caractérisé en ce que** l'aire de section pouvant être parcourue par l'air de refroidissement des canaux à air de refroidissement (6, 7) formés par les ailettes de refroidissement (4, 5) est égale dans toutes les zones de canaux à air de refroidissement.

7. Radiateur (2) selon l'une des revendications précédentes, **caractérisé en ce que** la surface de radiateur (32) de la platine de base (3) présente des rainures longitudinales (33) orientées dans le sens de circulation de l'air de refroidissement (x), les ailettes de refroidissement (4, 5) pouvant être introduites deux par deux côte à côte dans une des rainures longitudinales (33) de la surface de radiateur (32) de la platine de base (3).

8. Radiateur (2) selon l'une des revendications précédentes, **caractérisé en ce que** la première zone de transition (44, 54) s'étend presque sur toute la longueur des ailettes de refroidissement (4, 5), dans le sens de circulation de l'air de refroidissement (x).

9. Radiateur (2) selon l'une des revendications précédentes, **caractérisé en ce qu'**une des ailettes de refroidissement (4) de chaque paire d'ailettes de refroidissement (4, 5) voisines l'une de l'autre est conformée comme une plaque plane.

10. Radiateur (2) selon l'une des revendications précédentes, **caractérisé en ce qu'**il comporte une deuxième platine de base (8) avec une surface d'élément (81) sur laquelle au moins un autre élément à refroidir (1) peut être fixé et avec une surface de radiateur (82) opposée munie de rainures longitudinales (83) destinées à recevoir des deuxièmes extrémités (42, 52) des ailettes de refroidissement (4, 5).

11. Radiateur (2) selon l'une des revendications précédentes, **caractérisé en ce que** les premières et/ou deuxièmes extrémités (41, 42, 51, 52) des ailettes de refroidissement (4, 5) sont conformées de telle manière qu'elles sont contiguës alternativement, dans le sens de circulation de l'air de refroidissement (x), des premières et/ou deuxièmes extrémités (51, 52, 41, 42) des ailettes de refroidissement (5, 4) voisines, les premières et/ou deuxièmes extrémités (41, 42, 51, 52) des ailettes de refroidissement (4, 5) étant de préférence brasées sur une surface de radiateur (32) de la platine de base (3, 8).
